# EUROPÄISCHE PATENTSCHRIFT

(11) **EP 2 401 580 B1**
(45) Veröffentlichungstag und Bekanntmachung des Hinweises auf die Patenterteilung: **05.04.2017**
(21) Anmeldenummer: 10703284.9
(22) Anmeldetag: 11.02.2010
(51) Int. Cl.: G01C 19/56, G01C 19/574

(54) **MEMS-GYROSKOP ZUR ERMITTLUNG VON ROTATIONSBEWEGUNGEN UM EINE X-, Y- UND/ODER Z-ACHSE**
MEMS GYROSCOPE FOR DETECTING ROTATIONAL MOTIONS ABOUT AN X-, Y-, AND/OR Z-AXIS
GYROSCOPE MICRO-ÉLECTROMÉCANIQUE PERMETTANT DE DÉTERMINER DES MOUVEMENTS DE ROTATION AUTOUR D'UN AXE X, Y ET/OU Z

(30) Priorität: 27.02.2009 DE 102009001248
(43) Veröffentlichungstag der Anmeldung: 04.01.2012
(73) Patentinhaber: Maxim Integrated GmbH, 8403 Lebring (AT)
(72) Erfinder: ROCCHI, Alessandro, I-57013 Rosignano Solvay (LI) (IT)
(74) Vertreter: Bergmeier, Werner
(86) Internationale Anmeldenummer: PCT/EP2010/051714
(87) Internationale Veröffentlichungsnummer: WO 2010/097297

(56) Entgegenhaltungen:
- WO-A1-92/21000
- WO-A1-2009/156485

## Beschreibung

Die vorliegende Erfindung betrifft ein MEMS-Gyroskop zur Ermittlung von Rotationsbewegungen um eine x-, y- und/oder z-Achse, insbesondere als 3D-Sensor, mit einem Substrat und mit mehreren Antriebsmassen, welche oszillierend schwingen um bei einer Drehung des Substrats um die x-, y- und/oder z-Achse Corioliskräfte auf die Antriebsmassen zu erzeugen.

Aus der TW 286201 BB ist ein 3D mikro-elektro-mechanisches MEMS-Gyroskop bekannt. Hierbei werden Massen, welche an einem zentralen Anker angeordnet sind, in eine oszillierende Drehbewegung versetzt. Die Massen sind auf einem Substrat angeordnet und werden bei einem Drehmoment um die x-, oder y-Achse aufgrund einer hierbei auftretenden Corioliskraft um die y- bzw. x-Achse gekippt. Dies wird ermöglicht durch eine entsprechende Aufhängung dieser Antriebsmassen an dem Substrat. Bei einem Drehmoment um die z-Achse sind Teilmassen durch wiederum eine entsprechende Aufhängung dieser Teilmassen an den drehbar gelagerten Massen translatorisch auslenkbar. Sowohl die Kippbewegungen als auch die translatorische Bewegung kann mittels Sensoren erfasst werden und dient aufgrund ihrer Proportionalität zu der Drehbewegung des Substrats als Maß für die entsprechende Drehung um die x-, y- oder z-Achse. Die jeweiligen Auslenkungen sind jedoch nur sehr schwierig zu ermitteln.

Um ein dreidimensionales Gyroskop als 3D-Sensor schaffen zu können, bei welchem Drehungen in allen drei Achsen festgestellt werden können, hat D. Wood et al. in dem Artikel "A monolithic silicon gyroscope capable of sensing about three axes simultaneously" 1996 ein Gyroskop vorgeschlagen, welches ringförmig um einen zentralen Anker angeordnete oszillierende Massen aufweist. Diese Massen sind in der Lage sowohl Kipp- als auch Drehbewegungen aufgrund auftretender Corioliskräfte durchführen zu können. Nachteilig ist hierbei, dass die Fertigung eines solchen Sensors ebenso wie der Antrieb der bewegten Massen schwierig ist. Die Bewegungen der einzelnen Bestandteile des Sensors beeinflussen sich gegenseitig, so dass Messungen der Bewegung in x-, y- oder z-Richtung des Gyroskops keine ausreichende Genauigkeit liefern.

Aus der WO 92/21000 A1 ist ein gattungsgemäßes MEMS-Gyroskop zur Ermittlung von Rotationsbewegungen um eine x-, y und/oder z-Achse bekannt. Die Biegefedern 113 in D1 erlauben jedoch nur die Rotation einer Sensormasse um die z-Achse. Eine Rotation um die x- oder y-Achse ist damit ausgeschlossen. Darunter leidet die Erfassungsgenauigkeit des Gyroskops. Die Anordnung der Anker im Bereich des äußeren Umfangs der Sensormasse vergrößert darüber hinaus den erforderlichen Bauraum des Gyroskops.

Die WO 2009/156485 A1 offenbart ein Mikro-Gyroskop zur Ermittlung von Rotationsbewegungen um eine x-, y- oder z-Achse, bei welchem auf einem Substrat zumindest ein Anker befestigt ist. In allen Ausführungsbeispielen der WO 2009/156485 A1 sind mehrere radial zu dem Anker oszillierende Massen mittels Federn unmittelbar an dem Anker befestigt. Die oszillierenden Massen sind mit wenigstens einer weiteren, nicht oszillierenden, aber zusammen mit den oszillierenden Massen um den zumindest einen Anker drehbaren Masse verbunden.

Aufgabe der vorliegenden Erfindung ist es, ein MEMS-Gyroskop zur Ermittlung von Rotationsbewegungen um eine x-, y- und/oder z-Achse, insbesondere als 3D-Sensor mit hoher Erfassungsgenauigkeit zu schaffen.

Die Aufgabe wird gelöst mit einem MEMS-Gyroskop mit den Merkmalen des Anspruches 1.

Erfindungsgemäß weist das MEMS-Gyroskop zur Ermittlung von Rotationsbewegungen um eine x-, y- und/oder z-Achse ein Substrat auf sowie mehrere, mindestens zwei vorzugsweise vier radial zu einem Zentrum bewegbare Antriebsmassen. Antriebselemente versetzten die Antriebsmassen als Primärschwingung in eine oszillierende Schwingung um bei einer Drehung des Substrates um die x-, y- und/oder z-Achse Corioliskräfte auf die Antriebsmassen zu erzeugen. Die oszillierenden Antriebsmassen sind mit wenigstens einer weiteren, nicht oszillierenden, aber zusammen mit den oszillierenden Antriebsmassen auf dem Substrat um die x-, y- und/oder z-Achse drehbaren Sensormasse verbunden. Sensorelemente sind an dem MEMS-Gyroskop vorgesehen um Auslenkungen der Sensormasse und/oder der Antriebsmassen in Relation zum Substrat aufgrund der erzeugten Corioliskräfte als Sekundärschwingung zu erfassen. Die Sensormasse ist mit zumindest zwei, vorzugsweise vier Ankern zur drehbaren Befestigung mittels Federn auf dem Substrat angeordnet.

Erfindungsgemäß sind die oszillierenden Antriebsmassen an der Sensormasse befestigt und können unabhängig von der Sensormasse oszillieren. Die Sensormasse selbst ist schließlich über mindestens zwei Anker an dem Substrat befestigen. Die Befestigung an den Ankern erfolgt über Federn, welche Bewegungen der Sensormasse zusammen mit den Antriebsmassen relativ zum Substrat erlauben. Die Bewegungen erfolgen dabei als Drehbewegung um die aus der Zeichenebene herausragende z-Achse sowie als Kippbewegung um die in der Zeichenebene liegenden x- und y-Achse. Hierdurch sind unabhängig voneinander Rotationsbewegungen des Substrates bzw. des Gyroskops um eine x-Achse, eine y-Achse und/oder eine z-Achse mittels der Sensorelemente, welche an entsprechender Stelle angeordnet sind, zu ermitteln. Insbesondere bei der Ausgestaltung mit vier Ankern, mittels welcher die Sensormasse auf dem Substrat angeordnet ist, wird eine ausgeglichene Lagerung der Massen auf dem Substrat bewirkt. Das Auslenken der Massen aufgrund der auftretenden Corioliskräfte bei einer Drehbewegung des Substrats erfolgt in allen Richtungen gleichmäßig, so dass die Auslenkbewegungen in allen Richtungen gleichartig sind. Besonders vorteilhaft ist es hierbei, wenn die vier Anker sich auf der x- und der y-Achse befinden, wobei jeweils zwei der Anker auf einer dieser Achsen angeordnet sind. Hierdurch ist die Kippbewegung um die x-Achse gleichartig mit der Kippbewegung um die y-Achse.

Die Antriebsmassen sind an der Sensormasse mittels in Antriebsrichtung elastischen Biegefedern befestigt. Die Antriebsmassen können hierdurch in Antriebsrichtung oszillierend angetrieben werden, ohne dass sie relevanten Einfluss auf die Sensormasse nehmen. Die Antriebsbewegung der Antriebsmassen bewirkt somit keine unmittelbare Bewegung der Sensormasse, obwohl diese über die Biegefedern miteinander verbunden sind. Die Biegefedern sind dagegen in Richtungen, welche von der Antriebsrichtung abweichen relativ starr mit der Sensormasse verbunden, so dass die auf die Antriebsmassen einwirkenden Corioliskräfte in eine Kipp- oder Drehbewegung der Sensormasse zusammen mit den Antriebsmassen eingeleitet werden können.

Die Federn, mit welchen die Sensormasse an dem Anker befestigt sind, erlauben einerseits die beschriebene Kippbewegung um die x- bzw. y-Achse sowie eine Drehbewegung um die z-Achse. Gegenüber translatorischen Bewegungen in x- oder y-Richtung sind sie hingegen in ihrem Zusammenwirken steif. Hierdurch wird ein stabiles System geschaffen, welches steif gegenüber translatorischen Bewegungen, jedoch weich hinsichtlich rotatorischen Bewegungen der Sensormasse ist.

In einer vorzugsweisen Ausbildung der Erfindung umgibt die Sensormasse die Antriebsmassen in Form eines Rahmens. Dadurch können die Antriebsmassen gut in der Sensormasse aufgenommen werden und sorgen für einen störungsfreien Betrieb des Sensors. Durch den Rahmen wird auch gewährleistet, dass die Antriebsmassen gleichmäßig betrieben und gelagert werden können, so dass auch die daraus resultierenden Corioliskräfte und damit die entsprechenden Kippbewegungen gleichmäßig von den Antriebsmassen in die Sensormasse eingeleitet werden können.

Sind die Antriebsmassen paarweise punktsymmetrisch zu dem Zentrum des Sensors angeordnet, so können Antriebsvibrationen einfach ausbalanciert werden, so dass der Sensor in Ruhelage eine im Wesentlichen unbewegte Sensormasse aufweist. Die Sensormasse wird hierdurch nicht von den bewegten Antriebsmassen negativ beeinflusst oder gar in Schwingung versetzt, ohne dass Corioliskräfte auftreten.

Vorzugsweise sind die Sensorelemente zum Erfassen der Auslenkung der Massen um die x- oder y-Achse unterhalb der Sensormasse und/oder unterhalb der Antriebsmassen als horizontale Plattenkapazitäten oder als vertikale Kapazitäten in der Sensormasse angeordnet. Bei jeder der genannten Anordnungen kann die Auslenkung der Massen um die x- oder y-Achse in ihrer sekundär Schwingung als Änderung der Kapazität bzw. elektrischen Spannung erfasst werden. Die entsprechende Amplitude wirkt dabei als Maß für die auf den Drehratensensor wirkende Drehrate.

Zum Erfassen der Auslenkung der Massen um die z-Achse sind Sensorelemente vorzugsweise innerhalb oder außerhalb der Sensormasse als vertikale Kapazitäten oder als Kammelektroden angeordnet. Auch hierbei kann durch eine Änderung der elektrischen Größe auf die Drehrate um die z-Achse rückgeschlossen werden.

Die Befestigung der Sensormasse and dem Substrat erfolgt vorzugsweise mit Biegefedern. Durch die Biegefedern wird gewährleistet, dass die Sensormasse stabil mittels der entsprechenden Anker auf dem Substrat angeordnet ist. Die einzelnen Biegefedern sollen dabei so zusammenwirken, dass idealerweise die Sensormasse und die Antriebsmassen keinen Kontakt zu dem Substrat erhalten, wenn sie auf Grund der auftretenden Schwingungen durch die Corioliskraft ausgelenkt werden.

Die Biegefedern sind vorzugsweise so ausgeführt, dass sie eine Rotation der Sensormasse um die x-, y- und z-Achse erlauben. Damit werden Drehbewegungen des Substrats als Sekundärbewegung aufgrund der auftretenden Corioliskräfte in eine oszillierende Rotation der Sensormasse um die x-, y- und/oder z-Achse ermöglicht.

Vorzugsweise sind die Biegefedern so ausgebildet, dass sie eine Verschiebung der Sensormasse in x-, y- und/oder z-Richtung verhindern. Bezüglich einer translatorischen Verschiebung der Sensormasse auf dem Substrat sind die Biegefedern in ihrem Zusammenwirken steif ausgebildet, so dass eine Verschiebung der Sensormasse in linearer Richtung auf dem Substrat vermieden wird.

Insbesondere um ein gutes und empfindliches Auslenken der Sensormasse zu ermöglichen, ist vorgesehen, dass die Anker im Bereich des Zentrums des Sensors angeordnet sind. Die Biegefedern können hierdurch entsprechend lang ausgebildet werden, in der gewünschten Richtung eine geringe Federkonstante aufweisen und somit relativ weich sein. Eine Biegung bei einer entsprechenden Krafteinwirkung ist hierdurch leicht möglich. Die daran aufgehängte Sensormasse kann damit leicht und wiederholgenau bereits bei geringen Corioliskräften gekippt werden.

Vorzugsweise sind die Anker zwischen den Antriebsmassen angeordnet. Hierdurch ergibt sich eine gleichmäßige Verteilung von Ankerpunkten und bewegten Massen. Das Auslenken der Sensormasse kann hierdurch nach allen Richtungen gleichmäßig und zielgerichtet erfolgen.

In einer ganz besonders bevorzugten Ausführung der Erfindung sind die Antriebsmassen mit Synchronisierfedern miteinander verbunden. Hierdurch wird in vorteilhafter Weise bewirkt, dass die Bewegungen der Antriebsmassen synchron zueinander verlaufen, so dass keine Reaktionskräfte aus ungleichen Bewegungen der Antriebsmassen auf die Sensormasse einwirken. Dies würde dazu führen, dass die Sensormasse Auslenkungen erfährt, welche nicht auf Grund der Corioliskräfte verursacht sind. Hierdurch würden Messfehler entstehen, welche unerwünscht sind. Die Synchronisierfedern hingegen verbinden die einzelnen Antriebsmassen miteinander, so dass die Antriebsbewegungen der einzelnen Antriebsmassen gleich sind und einander bezüglich der auftretenden Kräfte ausgleichen.

Besonders vorteilhaft ist es, wenn die Synchronisierfedern sehr zentrumsnah angeordnet sind. Insbesondere, wenn sie sich näher am Zentrum befinden als die Anker der Sensormasse, wird sichergestellt, dass sich die Synchronisierfedern und die Biegefedern der Sensormasse nicht gegenseitig behindern. Darüber hinaus können die Biegefedern ebenso wie die Synchronisierfedern lang genug ausgeführt werden, so dass sie in der jeweiligen Richtung ausreichend elastisch sind, und sowohl die Beweglichkeit der Sensormasse als auch die Synchronisierung und Beweglichkeit der Antriebsmassen gewährleistet ist.

Sind die Antriebsrichtungen der Antriebsmassen winklig zueinander, bei vier Antriebsmassen vorzugsweise in einem 90°-Winkel oder bei drei Antriebsmassen vorzugsweise in einem 120°-Winkel vorgesehen, so wird sichergestellt, dass die Antriebsmassen gleichmässig betrieben werden können, ohne dass Kräfte auf die Sensormasse einwirken, welche nicht durch die Corioliskräfte verursacht sind.

Ein besonders stabiles System entsteht dadurch, dass in einer vorzugsweisen Ausführung der Erfindung die Antriebsrichtungen der Antriebselemente in einem 45°-Winkel zu den x-/y-Achsen vorgesehen sind. Hierdurch reagiert das System sehr empfindlich auf Corioliskräfte und ist bereits bei geringen Drehraten um die entsprechende Achse in der Lage, Corioliskräfte anzeigen zu können.

Vorzugsweise sind die Antriebselemente der Antriebsmassen Elektroden, insbesondere Gabel- bzw. Kammelektroden. Dabei ist ein Teil der Elektroden auf dem Substrat befestigt und ein anderer Teil der Elektroden an den Antriebselementen angeordnet. Durch das Anlegen einer Wechselspannung werden die Elektroden angezogen und abgestoßen, wodurch eine oszillierende Bewegung der Antriebsmassen entsteht.

Weitere Vorteile der Erfindung sind in nachfolgenden Ausführungsbeispielen beschrieben. Es zeigt:
- **Figur 1**: ein erfindungsgemäßes MEMS-Gyroskop in einer Draufsicht,
- **Figur 2**: ein weiteres MEMS-Gyroskop in Draufsicht und
- **Figur 3**: ein weiteres MEMS-Gyroskop in Draufsicht.

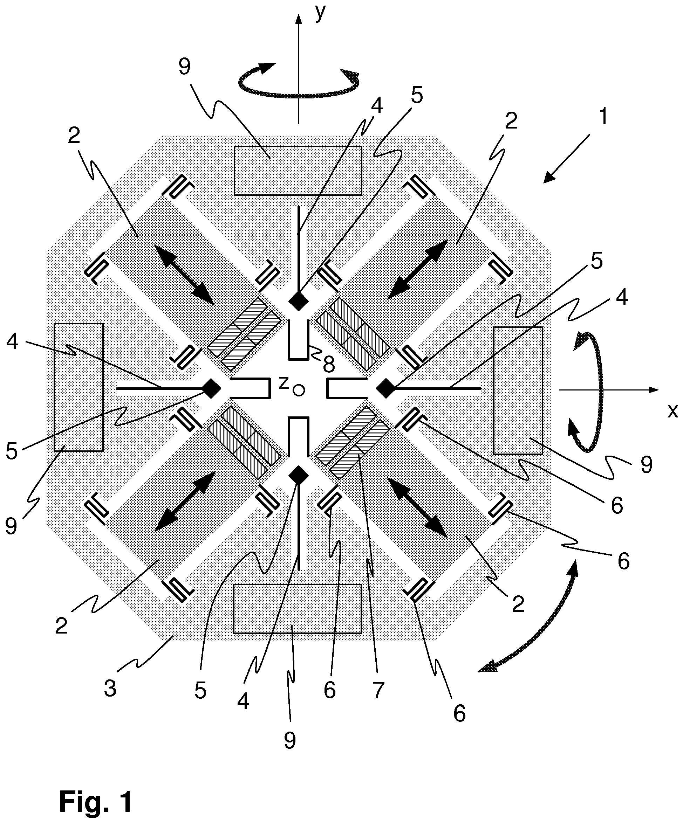

In Figur 1 ist die Draufsicht eines 3D-MEMS-Gyroskops 1 dargestellt. Zu sehen sind hierbei insbesondere die bewegten Teile des Gyroskops 1, nämlich vier Antriebsmassen 2 und eine Sensormasse 3. Die Sensormasse 3 umgibt die vier Antriebsmassen 2 rahmenartig. Die Antriebsmassen 2 befinden sich innerhalb der Sensormasse 3.

Die Sensormasse 3 ist über Biegefedern 4 und Anker 5 auf einem nicht dargestellten Substrat angeordnet. Die Biegefedern 4 sind biegeweich in Querrichtung zu ihrer Längserstreckung. In ihrer Längsstreckung sind sie jedoch steif. Hierdurch wird bewirkt, dass die Sensormasse 3 um eine in der Zeichenebene liegende x-Achse und y-Achse ebenso wie um eine aus der Zeichenebene herausragende z-Achse drehbar ist. Die oszillierenden Drehbewegungen sind mit entsprechenden Pfeilen dargestellt.

Umrahmt von der Sensormasse 3 sind die Antriebsmassen 2 angeordnet. Die Antriebsmassen 2 sind mittels Biegefedern 6 an der Sensormasse 3 befestigt. Jede der Antriebsmassen 2 weist vier dieser Biegefedern 6 auf. Die Antriebsmassen 2 werden mittels Antriebselementen 7 in Doppelpfeilrichtung oszillierend angetrieben. Die Antriebselemente 7 bestehen beispielsweise aus Kammelektroden, von denen einige am Substrat und andere an der Antriebsmasse 2 befestigt sind und somit durch eine angelegte Wechselspannung die Antriebsmasse 2 in eine oszillierende Schwingung versetzen.

Die Biegefedern 6 sind derart ausgebildet, dass sie in der Antriebsrichtung der Antriebsmasse 2 biegeelastisch sind, in allen anderen Richtungen jedoch steif ausgebildet sind. Hierdurch wird bewirkt, dass die Antriebsmasse 2 in ihrer Antriebsrichtung weitgehend frei schwingen kann, während in den anderen Richtungen die Antriebsmasse 2 an die Bewegungen der Sensormasse 3 gekoppelt ist. Durch eine Corioliskraft, welche bei einer Drehbewegung des Substrats um eine oder mehrere der Achsen x, y und/oder z entsteht, wird somit die Sensormasse 3 zusammen mit den Antriebsmassen 2 in eine entsprechende Richtung als Sekundärbewegung gedreht.

Die vier Antriebsmassen 2 sind derart in der Sensormasse 3 angeordnet, dass sie paarweise gegeneinander schwingen und punktsymmetrisch zur z-Achse angeordnet sind. Hierdurch heben sich Kräfte und Drehmomente, welche durch die Bewegung der Antriebsmassen 2 entstehen könnten, gegenseitig auf und die Sensormasse 3 wird nur auf Grund der Antriebsbewegung der Antriebsmassen 2 nicht in eine Bewegung versetzt.

Um dieses Gleichgewicht und damit die Ruhe der Sensormasse 3 zu gewährleisten sind die Antriebsmassen 2 mittels Synchronisierfedern 8 miteinander verbunden. Die Synchronisierfedern 8 sind zwischen dem Anker 5 und dem Zentrum des Gyroskops 1 an der z-Achse angeordnet. Hierdurch wird sichergestellt, dass sie nicht mit der Bewegung der Biegefedern 4 bzw. dem Anker 5 in Konflikt geraten. Die Synchronisierfedern 8 sind u-förmig ausgebildet. Bei einer periodisch von einander weg und wieder zu einander hin erfolgenden Bewegung der durch die Synchronisierfedern 8 miteinander verbundenen beiden Antriebsmassen 2 ergibt sich ein sich verändernder Abstand der beiden Antriebsmassen 2. Die Synchronisierfedern 8 können sich dabei wegen ihrer Formgebung entsprechend spreizen. Die Synchronisierfedern 8 nutzen dabei Kräfte auf die Antriebsmassen 2 dahingehend aus, dass Geschwindigkeitsunterschiede ausgeglichen werden und damit die Antriebsbewegungen der vier Antriebsmassen 2 synchron erfolgen.

Unterhalb der Sensormasse 3 sind im Bereich der x- und der y-Achse Plattenkapazitäten 9 angeordnet. Durch diese Plattenkapazitäten 9 wird ein elektrisches Signal erzeugt, sobald es sich die Sensormasse 3 um die x- oder y-Achse dreht. Diese Signal ist proportional zur Coriofiskraft, welche durch eine Drehbewegung des Substrats um die x- oder y-Achse entsteht. Zur Erfassung der Drehbewegung der Sensormasse 3 um die z-Achse sind beispielsweise Kammelektroden insbesondere am Umfang oder äußeren Bereich der Sensormasse 3 vorgesehen, welche eine Drehbewegung der Sensormasse 3 um die z-Achse ebenfalls in Form eines elektrischen Signals erfassen und Rückschlüsse auf eine entsprechende Drehbewegung des Substrats zulassen.

Durch die Befestigung der Sensormasse 3 an dem Anker 5 des Substrats über die Biegefedern 4 sowie durch die Befestigung der Antriebsmassen 2 über die Biegefedern 6 an der Sensormasse 3 entsteht ein System, bei welchem die Primärbewegung der Antriebsmassen 2 weitestgehend entkoppelt ist von der Sekundärbewegung, welche durch die Antriebsmassen 2 und die Kopplung mit der Sensormasse 3 erfolgt. Die Drehbewegung von Antriebsmassen 2 und Sensormasse 3 als Reaktion auf eine Drehbewegung des Gyroskops 1 bzw. des Substrats, auf welchem die Sensormasse 3 und die Antriebsmassen 2 befestigt sind, kann ohne, dass sie durch die Antriebsbewegung der Antriebsmassen 2 gestört wird, sensiert werden.

Nachdem die Sekundärbewegung durch die Antriebsmassen 2 und die Sensormasse 3 gekoppelt erfolgt, ist es alternativ zu diesem Ausführungsbeispiel auch möglich, dass die Sensorelemente, hier die Plattenkapazitäten 9, nicht nur unterhalb der Sensormasse 3, sondern auch unter den Antriebsmassen 2 angeordnet sind. Gleiches gilt selbstverständlich für die Sensorelemente, welche die Drehbewegung um die z-Achse Erfassen. Auch hier erfolgt die Bewegung durch die Antriebsmassen 2 und die Sensormasse 3 gemeinsam, so dass diese Bewegung auch im Bereich der Antriebsmassen und/oder der Sensormasse 3 erfolgen kann.

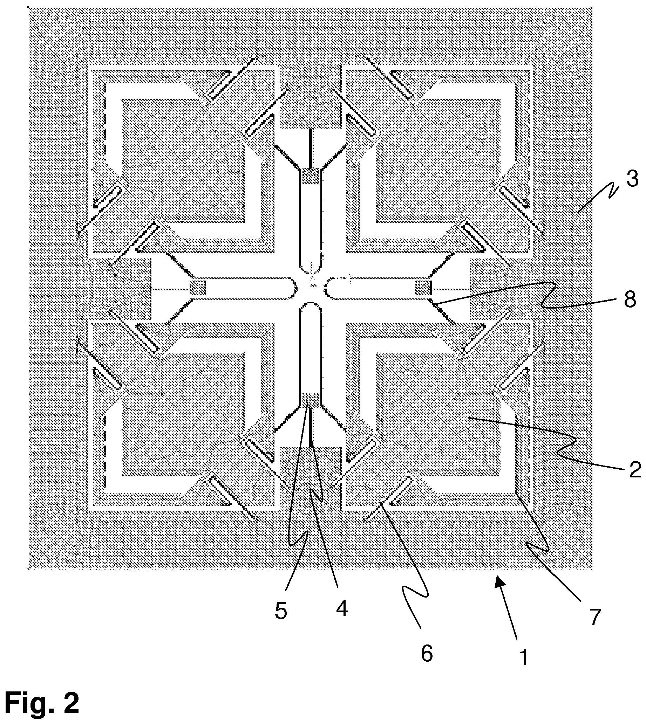

In Figur 2 ist ein alternatives Ausführungsbeispiel zu dem MEMS-Gyroskop der Figur 1 dargestellt. Vergleichbare Bauelemente sind mit dem gleichen Bezugszeichen wie in Figur 1 bezeichnet. Ebenso wie in Figur 1 weist das MEMS-Gyroskop 1 vier Antriebsmassen 2 auf, welche mittels jeweils vier Biegefedern 6 mit der Sensormasse 3 verbunden sind. Die Sensormasse 3 umgibt die vier Antriebsmassen 2 rahmenartig. Die Antriebsmassen 2 bewegen sich im 45°-Winkel zur x- und y-Achse in einer Richtung, welche durch das Zentrum des Gyroskops 1 im Bereich der z-Achse verläuft, hin und wieder von diesem weg. Gegenüberliegende Antriebsmassen 2 bewegen sich gegenläufig oszillierend um so Vibrationen auf die Sensormasse 3 zu vermeiden,

Die Sensormasse 3 ist mittels jeweils einer Biegefeder 4 an jeweils einem, insgesamt an vier Ankern 5 dreh- und kippbar um die x-, y- und z-Achse verankert. Zwischen den Ankern 5 und dem Zentrum des Gyroskops 1 erstrecken sich die Synchronisierfedern 8, welche dafür sorgen, dass die Antriebsmassen 2 synchron zueinander schwingen. Die Biegefedern 6, mit welchen die Antriebsmassen 2 mit der Sensormasse 3 verbunden sind, erlauben in Antriebsrichtung die oszillierenden Bewegungen der Antriebsmassen 2, sind jedoch in allen anderen Richtungen starr, so dass auftretende Corioliskräfte von den Antriebsmassen 2 auf die Sensormasse 3 übertragen werden können.

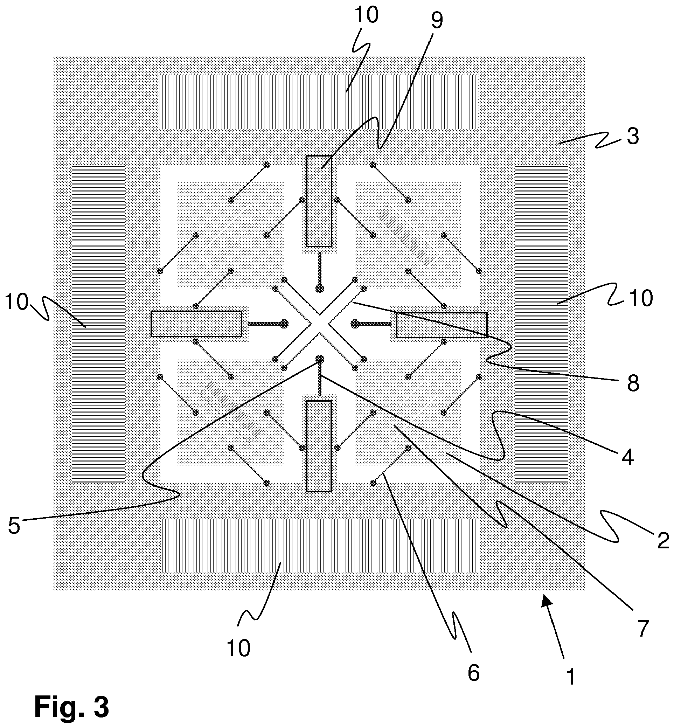

In Figur 3 ist eine weitere Ausführung eines erfindungsgemäßen 3D-MEMS-Gyroskops 1 schematisch dargestellt. Die Verbindung der Antriebsmassen 2 mit der Sensormasse 3 sowie die Verbindung der Sensormasse 3 über die Biegefedern 4 und die Anker 5 auf dem Substrat erfolgen in ähnlicher Weise wie bei den Ausführungsbeispielen in Figuren 1 und 2. Die Synchronisierfedern 8 sind bei dieser Ausführung pfeilartig ausgebildet, aber ebenfalls in Richtung auf das Zentrum des Gyroskops 1 hin orientiert. Die Erfassung der Drehbewegung der Sensormasse 3 und der Antriebsmassen 2 um die x-, y- oder z-Achse erfolgt bei dieser Ausführung der Erfindung mittels Sensorelementen 10, welche im Rahmen der Sensormasse 3 angeordnet sind. Diese Sensorelemente 10 sind beispielsweise vertikale Kapazitäten, welche bei einer Drehbewegung der Sensormasse 3 um die z-Achse veränderliche elektrische Signale erzeugen. Bei einer entsprechenden Ausbildung kann mit diesen Sensorelementen 10 oder mit ähnlichen Sensorelementen oder aber auch mit Plattenkapazitäten, wie in der Ausführung der Figur 1 dargestellt, die Drehbewegung um die x- oder y-Achse der Sensormasse 3 erfasst werden.

Die Erfindung ist nicht auf die dargestellten Ausführungsbeispiele beschränkt. So kann insbesondere die Anzahl der Antriebsmassen unterschiedlich von der hier dargestellten Anzahl sei. Auch die Art und Weise der Erfassung der Drehbewegung der Sensormasse 3 kann anders als hier dargestellt erfolgen. Die Gestaltung der Antriebsmassen 2 und der Sensormasse 3 muss darüber hinaus nicht eckig sein, sondern kann in einer anderen Ausführung der Erfindung auch abgerundet oder rund sein. Im Übrigen betrifft die Erfindung alle Ausführungen, welche entsprechend der geltenden Patentansprüche ausgebildet sind.

## Patentansprüche

1. MEMS-Gyroskop zur Ermittlung von Rotationsbewegungen um eine x-, y- und/oder z-Achse, insbesondere als 3D-Sensor,
mit einem Substrat,
mit mehreren, mindestens zwei, vorzugsweise vier radial zu einem Zentrum bewegbaren Antriebsmassen (2),
mit Antriebselementen (7) zum oszillierenden Schwingen der Antriebsmassen (2) um bei einer Drehung des Substrats um die x-, y- und/oder z-Achse Corioliskräfte auf die Antriebsmassen (2) zu erzeugen und wobei die oszillierenden Antriebsmassen (2) mit wenigstens einer weiteren, nicht oszillierenden, aber zusammen mit den oszillierenden Antriebsmassen (2) auf dem Substrat um die x-, y- und/oder z-Achse drehbaren Sensormasse (3) verbunden sind und
mit Sensorelementen (9, 10), um Auslenkungen der Sensormasse (3) und/oder Antriebsmassen (2) in Relation zum Substrat aufgrund der erzeugten Corioliskräfte zu erfassen, und
mit zumindest zwei, vorzugsweise vier Ankern (5) zur drehbaren Befestigung der Sensormasse (3) mittels Federn (4) auf dem Substrat, wobei die Sensormasse (3) mit Biegefedern (4) an den Ankern (5) des Substrats befestigt ist und
die oszillierenden Antriebsmassen (2) - ohne unmittelbare Verbindung mit dem Substrat - an der Sensormasse (3) mittels in Antriebsrichtung elastischen Biegefedern (6) befestigt sind,
**dadurch gekennzeichnet,,**
**dass** die Biegefedern (4) eine Rotation der Sensormasse (3) um die x-, y- und z-Achse erlauben.

2. MEMS-Gyroskop nach Anspruch 1, dadurch gekenntzeichnet, dass die Sensormasse (3) die Antriebsmassen (2) als ein Rahmen umgibt.

3. MEMS-Gyroskop nach einem oder mehreren der vorherigen Ansprüche, **dadurch gekennzeichnet, dass** die Antriebsmassen (2) paarweise punktsymmetrisch zu dem Zentrum des Sensors (1) angeordnet sind um Antriebsvibrationen auszubalancieren.

4. MEMS-Gyroskop nach einem oder mehreren der vorherigen Ansprüche, **dadurch gekennzeichnet, dass** Sensorelemente (9, 10) zum Erfassen der Auslenkung der Massen (2, 3) um die x- und/oder y-Achse unterhalb der Sensormasse (3) und/oder der Antriebsmassen (2) als horizontale Plattenkapazitäten (9) oder als vertikale Kapazitäten (10) in der Sensormasse (3) angeordnet sind.

5. MEMS-Gyroskop nach einem oder mehreren der vorherigen Ansprüche, dadurch gekenntzeichnet, dass Sensorelemente (10) zum Erfassen der Auslenkung der Massen (2, 3) um die z-Achse innerhalb und/oder außerhalb der Sensormasse (3) als vertikale Kapazitäten oder als Kammelektroden angeordnet sind.

6. MEMS-Gyroskop nach einem oder mehreren der vorherigen Ansprüche, dadurch gekenntzeichnet, dass die Biegefedern (4) derart ausgebildet sind, dass sie eine Verschiebung der Sensormasse (3) in x-, y- oder z-Richtung vermeiden.

7. MEMS-Gyroskop nach einem oder mehreren der vorherigen Ansprüche, **dadurch gekennzeichnet, dass** die Anker (5) im Bereich des Zentrums angeordnet sind.

8. MEMS-Gyroskop nach einem oder mehreren der vorherigen Ansprüche, dadurch gekenntzeichnet, dass die Anker (5) zwischen den Antriebsmassen (2) angeordnet sind.

9. MEMS-Gyroskop nach einem oder mehreren der vorherigen Ansprüche, dadurch gekenntzeichnet, dass die Antriebsmassen (2) mit Synchronisierfedern (8) miteinander verbunden sind.

10. MEMS-Gyroskop nach einem oder mehreren der vorherigen Ansprüche, **dadurch gekennzeichnet, dass** die Antriebsrichtungen winkelig zueinander, vorzugsweise in einem 90°- oder 120°-Winkel vorgesehen sind.

11. MEMS-Gyroskop nach einem oder mehreren der vorherigen Ansprüche, **dadurch gekennzeichnet, dass** die Antriebsrichtungen in einem 45°-Winkel zu den x-/y-Achsen vorgesehen sind.

12. MEMS-Gyroskop nach einem oder mehreren der vorherigen Ansprüche, **dadurch gekennzeichnet, dass** die Antriebselemente (7) der Antriebsmassen (2) Elektroden, insbesondere Gabelelektroden, sind.

## Claims

1. MEMS gyroscope for detecting rotary movements about an x, y and/or z axis, particularly as a three-dimensional sensor,
with a substrate,
with multiple, at least two, preferably four driving masses (2) movable radially relative to a central point,
with drive elements (7) for the oscillating vibration of the driving masses (2) in order to generate Coriolis forces on the driving masses (2) in the event of rotation of the substrate about the x, y and/or z axis and
wherein the oscillating driving masses (2) are connected to at least one additional sensor mass (3), which is non-oscillating but which can be rotated on the substrate about the x, y and/or z axis together with the oscillating driving masses (2) and
with sensor elements (9, 10), in order to detect displacements of the sensor mass (3) and/or the driving masses (2) in relation to the substrate as a result of the generated Coriolis forces, and
with at least two, preferably four anchoring devices (5) for the rotary attachment of the sensor mass (3) to the substrate by means of springs (4)
wherein the sensor mass (3) is attached to the anchoring devices (5) of the substrate by means of flexural springs (4) and
the oscillating driving masses (2) - being not directly connected to the substrate - are fixed to the sensor mass (3) by means of flexural springs (6), that are elastic in drive direction
**characterized in that**
the flexural springs (4) enable a rotation of the sensor mass (3) about the x, y and z axis.

2. MEMS gyroscope according to Claim 1, **characterised in that**, the sensor mass (3) encloses the driving masses (2) as a frame.

3. MEMS gyroscope according to one or more of the preceding claims,
**characterised in that** the driving masses (2) are arranged in pairs and point-symmetrically relative to the central point of the sensor (1) in order to balance out drive vibrations.

4. MEMS gyroscope according to one or more of the preceding claims,
**characterised in that** sensor elements (9, 10) for detecting the displacement of the masses (2, 3) about the x and/or y axis are arranged below the sensor mass (3) and/or the driving masses (2) as horizontal plate capacitances (9) or are arranged within the sensor mass (3) as vertical capacitances (10).

5. MEMS gyroscope according to one or more of the preceding claims,
**characterised in that** sensor elements (10) to detect the displacement of the masses (2, 3) about the z axis are arranged within and/or outside the sensor mass (3) as vertical capacitances or as comb electrodes.

6. MEMS gyroscope according to one or more of the preceding claims,
**characterised in that** the flexural springs (4) are designed in such a way that they prevent a displacement of the sensor mass (3) in the x, y or z direction.

7. MEMS gyroscope according to one or more of the preceding claims,
**characterised in that** the anchoring devices (5) are arranged in the region of the central point.

8. MEMS gyroscope according to one or more of the preceding claims,
**characterised in that** the anchoring devices (5) are arranged between the driving masses (2).

9. MEMS gyroscope according to one or more of the preceding claims,
**characterised in that** the driving masses (2) are connected together by synchronising springs (8).

10. MEMS gyroscope according to one or more of the preceding claims,
**characterised in that** the drive directions are inclined relative to each other, preferably at an angle of 90° or 120°.

11. MEMS gyroscope according to one or more of the preceding claims,
**characterised in that** the drive directions are provided at an angle of 45° to the x/y axes.

12. MEMS gyroscope according to one or more of the preceding claims,
**characterised in that** the drive elements (7) of the drive masses (2) are electrodes, in particular fork electrodes.

## Revendications

1. Gyroscope de système micro-électromécanique pour la détermination de mouvements de rotation autour d'un axe x, y et/ou z, en particulier en tant que capteur 3D,
avec un substrat,
avec plusieurs, au moins deux, de préférence quatre masses d'entraînement (2) mobiles radialement par rapport à un centre,
avec des éléments d'entraînement (7) pour la vibration en oscillation des masses d'entraînement (2) pour, lors d'une rotation du substrat autour de l'axe x, y et/ou z, générer des forces de Coriolis sur les masses d'entraînement (2) et sachant que les masses d'entraînement oscillantes (2) sont reliées avec au moins une masse sensorielle (3) supplémentaire non oscillante, mais rotative autour de l'axe x, y et/ou z en même temps que les masses d'entraînement (2) oscillantes sur le substrat et
avec des éléments capteurs (9, 10), afin de capter des déviations de la masse sensorielle (3) et/ou des masses d'entraînement (2) par rapport au substrat en raison des forces de Coriolis générées, et
avec au moins deux, de préférence quatre ancres (5) pour la fixation rotative de la masse sensorielle (3) au moyen de ressorts (4) sur le substrat, sachant que la masse sensorielle (3) est fixée à l'aide de ressorts de flexion (4) sur les ancres (5) du substrat et
les masses d'entraînement oscillantes (2) - sans connexion directe avec le substrat - sont fixées sur la masse sensorielle (3) à l'aide de ressorts de flexion (6) élastiques dans la direction d'entraînement, **caractérisé en ce que**
les ressorts de flexion (4) permettent une rotation de la masse sensorielle (3) autour de l'axe x, y et/ou z.

2. Gyroscope de système micro-électromécanique selon la revendication 1, **caractérisé en ce que** la masse sensorielle (3) entoure les masses d'entraînement (2) en tant que cadre.

3. Gyroscope de système micro-électromécanique selon l'une ou plusieurs des revendications précédentes, **caractérisé en ce que** les masses d'entraînement (2) sont disposées en paires en symétrie ponctuelle par rapport au centre du capteur (1) afin d'équilibrer les vibrations d'entraînement.

4. Gyroscope de système micro-électromécanique selon l'une ou plusieurs des revendications précédentes, **caractérisé en ce que** des éléments capteurs (9, 10) pour capter la déviation des masses (2, 3) autour de l'axe x et/ou y sont disposés sous la masse sensorielle (3) et/ou les masses d'entraînement (2) en tant que capacités de disques horizontales (9) ou en tant que capacités verticales (10) dans la masse sensorielle (3).

5. Gyroscope de système micro-électromécanique selon l'une ou plusieurs des revendications précédentes, **caractérisé en ce que** des éléments capteurs (10) pour capter la déviation des masses (2, 3) autour de l'axe z sont disposés au sein et/ou hors de la masse sensorielle (3) en tant que capacités verticales ou en tant qu'électrodes en peigne.

6. Gyroscope de système micro-électromécanique selon l'une ou plusieurs des revendications précédentes, **caractérisé en ce que** les ressorts de flexion (4) se présentent sous une forme telle qu'ils empêchent un décalage de la masse sensorielle (3) dans la direction x, y ou z.

7. Gyroscope de système micro-électromécanique selon l'une ou plusieurs des revendications précédentes, **caractérisé en ce que** les ancres (5) sont disposées dans la zone du centre.

8. Gyroscope de système micro-électromécanique selon l'une ou plusieurs des revendications précédentes, **caractérisé en ce que** les ancres (5) sont
disposées entre les masses d'entraînement (2).

9. Gyroscope de système micro-électromécanique selon l'une ou plusieurs des revendications précédentes, **caractérisé en ce que** les masses d'entraînement (2) sont reliées les unes avec les autres par des ressorts de synchronisation (8).

10. Gyroscope de système micro-électromécanique selon l'une ou plusieurs des revendications précédentes, **caractérisé en ce que** les directions d'entraînement sont prévues à un angle l'une de l'autre, de préférence à un angle de 90° ou de 120°.

11. Gyroscope de système micro-électromécanique selon l'une ou plusieurs des revendications précédentes, **caractérisé en ce que** les directions d'entraînement sont prévues à un angle 45° par rapport aux axes x/y.

12. Gyroscope de système micro-électromécanique selon l'une ou plusieurs des revendications précédentes, **caractérisé en ce que** les éléments d'entraînement (7) des masses d'entraînement (2) sont des électrodes, en particulier des électrodes en fourche.
